(19) Europäisches Patentamt European Patent Office Office européen des brevets

(11) **EP 3 376 614 A1**

(12) **EUROPEAN PATENT APPLICATION**

(43) Date of publication:
**19.09.2018 Bulletin 2018/38**

(51) Int Cl.:
*H01S 5/026* (2006.01)    *H01S 5/10* (2006.01)
*H01S 5/50* (2006.01)

(21) Application number: **17305283.8**

(22) Date of filing: **15.03.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Nokia Solutions and Networks Oy 02610 Espoo (FI)**

(72) Inventors:
• **BRENOT, Romain**
  **91767 PALAISEAU (FR)**
• **LE LIEPVRE, Alban**
  **91767 PALAISEAU (FR)**

(74) Representative: **Novagraaf Technologies Bâtiment O2 2, rue Sarah Bernhardt CS90017 92665 Asnières-sur-Seine Cedex (FR)**

(54) **INTEGRATED MEASUREMENT OF SOA GAIN**

(57) The present invention relates to a Semiconductor Optical Amplifier (SOA) 100 comprising :
- a waveguide adapted to transmit and amplify an optical signal; and
- integrated control means adapted to measure the gain of the SOA 100.

**Fig. 5**

## Description

### Field of the Invention

The present invention relates to a Semiconductor Optical Amplifier (SOA).

### Background

Optical amplifiers (OAs) such as Semiconductor Optical Amplifier (SOA) and Erbium Doped Fibre Amplifier (EDFA) are broadly used in lasers.

In order to control the output power and/or the gain flatness of an Optical Amplifier (OA), it is necessary to measure its input power. Besides, if a second stage is used with a Variable Optical Attenuator (VOA) in between, it is necessary to measure the output power of the first OA stage.

In short, for practical applications, it is necessary to measure both the input and output powers of an OA, which corresponds to gain measurement. Such a measurement is also useful to monitor the ageing of the OA and to detect any failure.

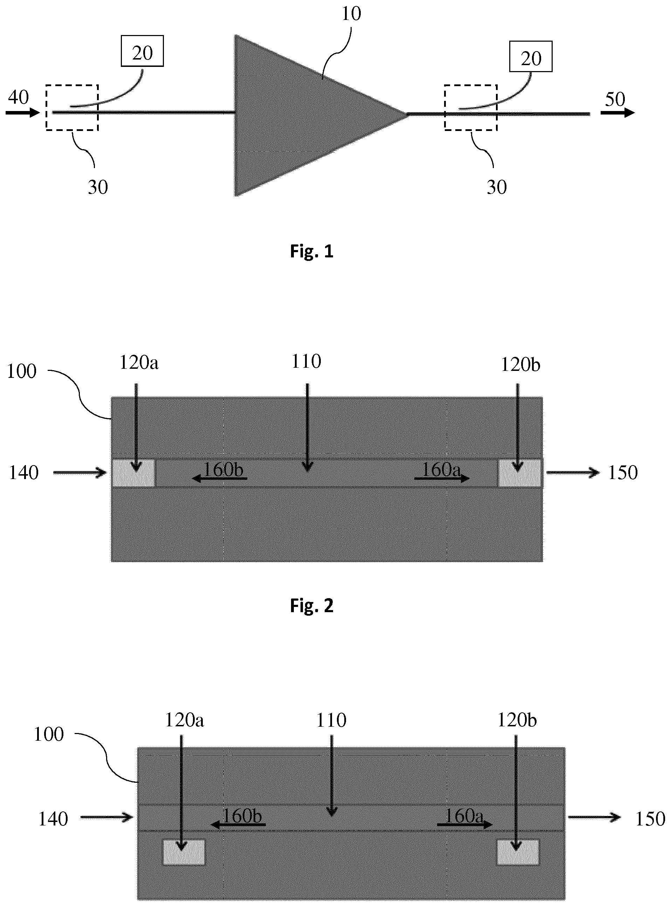

Current commercial OA products are not equipped with gain measurement. In the case of EDFA, gain measurement is performed with a 1% tap 30 and a monitoring photodiodes 20 arrangement inserted at the entry and at the end of an EDFA 10 as shown in **Figure 1.**

The same configuration can be used with SOA. However, SOA are meant to reduce the cost and the size of optical amplifiers compared to EDFA but no change was made to current gain measurement systems.

### Summary

The present invention proposes a Semiconductor Optical Amplifier (SOA) to address the needs of low cost and compact optical amplifier and solve the prior art drawbacks.

In a first general embodiment, a Semiconductor Optical Amplifier (SOA) comprises :

- a waveguide adapted to transmit and amplify an optical signal; and
- integrated control means adapted to measure the gain of the SOA.

Advantageously, the control means comprise at their entry a first section adapted to measure the input power and, at its end, a second section adapted to measure the output power.

Advantageously, the control means further comprise a waveguide coupled to the first waveguide, the waveguide been parallel to the first waveguide, and the first and second sections been photodiodes implemented at the extremity of the coupled waveguide.

Advantageously the distance between both waveguides is adapted to make sure that the monitoring will not lead to reflections and/or optical losses.

To improve the precision of the measures, the input and output facets of the Semiconductor Optical Amplifier medium can be tilted, and the first an second sections are located at the opposite of the tilts, so that an Amplified Spontaneous Emission generated in the Semiconductor Optical Amplifier would not be detected by the photodiodes of the first and second section (120a, 120b).

### Brief Description of the Drawings

Some embodiments of apparatus in accordance with embodiments of the present invention are now described, by way of example only, and with reference to the accompagnying drawings, in which :

- The Figure 1 schematically illustrates a gain measurement configuration for an Erbium Doped Fibre Amplifier (EDFA);
- The Figure 2 schematically illustrates a first general embodiment of the present invention;
- The Figure 3 schematically illustrates a second general embodiment of the present invention;
- The Figure 4 schematically illustrates a particular embodiment of the present invention;
- The Figure 5 schematically illustrates a particular embodiment of the present invention;
- The Figure 6 schematically illustrates a cross section of the embodiment of Figure 4;
- The Figure 7 schematically illustrates the modeling propagation of an input signal in the embodiment of Figure 4;
- The Figure 8 schematically illustrates the coupling coefficient variation with waveguide spacing for the embodiment of Figure 4; and
- The Figure 9 schematically illustrates the photodetector port output power variation with waveguide spacing for a 100 $\mu$m long coupler in the cas of the particular embodiment shown in Figure 4.

### Description of Embodiments

As previously described, **Figure 1** shows the current configuration used to measure the gain of an Erbium Doped Fibre Amplifier (EDFA) 10.

Before the EDFA 10 input, a 1% tap 30 samples a determined part of the input optical signal and sends it to a photodiode 20 adapted to measure the input power 40.

A similar assembly is arranged at the EDFA 10 output in order to measure the output power 50. The EDFA gain can then be deduced by calculating the ratio between the two values.

Instead of proposing such an assembly to measure and control the gain of a Semiconductor Optical Amplifier (SOA) which would reduce the advantages of using a SOA, namely the compactness and low cost, the present invention proposes an integrated gain measurement inside the SOA module and more precisely inside the SOA chip.

**Figure 2** shows a first general embodiment of the invention. The SOA chip 100 comprises a SOA medium 110 (which can be identified as a waveguide) and two sections 120a, 120b, adapted to measure the power of an input 140 and output 150 optical signal. The first section 120a is located at the input of the SOA chip 100 and before the SOA medium 110 to measure the input power 140. The second section 120b is located after the SOA medium 110, at the output of the SOA chip 100, to measure the output power 150.

**Figure 3** shows a second general embodiment of the invention. In this embodiment, the first and second section 120a, 120b, are located near the input and ouput and receive a determined part of the optical signal to measure its input and output power 140, 150.

These sections 120a, 120b, can be photodiodes which monitor the photocurrent generated by the absorption of a small percentage of an optical signal and located next to the input and output of the SOA medium 110.

However, in a SOA, there is Amplified Spontaneous Emission (ASE) 160 propagating in both directions, forward 160a and backward 160b as shown in **Figures 2 and 3.**

In particular, the input power 140 of the SOA is very often smaller than the ASE power 160. Since a photodiode can not distinguish between input signal photons or ASE photons (both photons roughly correspond similar photodiode responsitivities), both first and second general embodiments described above would in many cases not be useful to measure the input power 140.

In fact, in these first and second general embodiment, the power measured by the two sections 120a and 120b can be expressed like this:

$$P_{120a} \sim P_{140} + |P_{ASE}|$$

$$P_{120b} \sim P_{150} + |P_{ASE}|$$

Typically, ASE power is 0 dBm in a SOA with a gain of 25 dB.

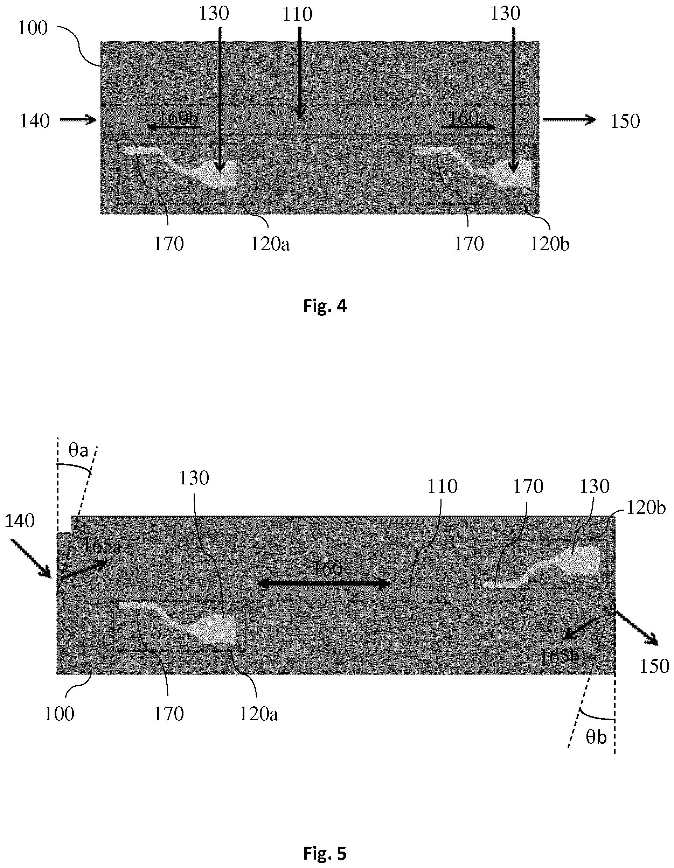

**Figure 4** illustrates a particular embodiment of the SOA 100 which enables to discriminate between the ASE photons and the input signal photons. In this embodiment, the first and second sections 120a, 120b comprise:

- a coupled waveguide 170, parallel to the SOA medium 110 and adapted to duplicate the optical signal passing through the SOA medium 110; and
- a photodiode 130 implemented at the extremity of the coupled waveguide 170 and adapted to measure the power of the signal duplicated by the coupled waveguide 170.

In this configuration, the backward ASE power 160b will not be detected by the input photodiode 130, so the input power 140 measured by the first section 120a can be expresses like this : $P_{120a} \sim P_{140}$.

The forward ASE power 160a is still detected by the output photodiode 130. However after amplification, the output optical signal power 150 is of the same range as the ASE power 160 or even higher. Thus it can be detected by the output photodiode 130.

To limit reflections at the facets of the SOA medium 110, the active stripe is tilted at the facets by typically $\theta a$, $\theta b \approx 7°$. Some parasitic reflections 165a and 165b of the ASE are present on one side of the active stripe. These reflections 165a and 165b of the ASE can be detected by the photodiode 130 if they are located on the same side than the tilt.

**Figure 5** shows a preferred implementation of the first and second sections 120a, 120b to avoid such an unwanted reflection detection, which limits the sensitivity of the proposed configuration, especially for the input photodiode 130 since the detected signal can be smaller than the ASE power 160. In this embodiment, the first and second sections 120a and 120b are located at the opposite of the tilts $\theta a$ and $\theta b$.

The dark current of the photodiodes 130 i.e. the photocurrent detected in the absence of an input optical signal is characteristic of the SOA. Its evolution over time can be used to detect an ageing of the SOA.

Such design is difficult to implement because the power measurement requires a sufficient sensitivity and precision.

So the design of the waveguide 170 must achieve :

- a sufficient coupling efficiency with the SOA medium 110 to obtain a sufficient sensitivity;
- a sufficient distance between the SOA medium 110, identified as the main waveguide, and the coupled waveguide 170 to make sure that monitoring will not lead to reflections and/or to optical losses.

A modelling of the coupling efficiency has been made on a SOA design having such a particular configuration for large output power, typically 20 dBm and wide optical bandwith, typically 100 nm.

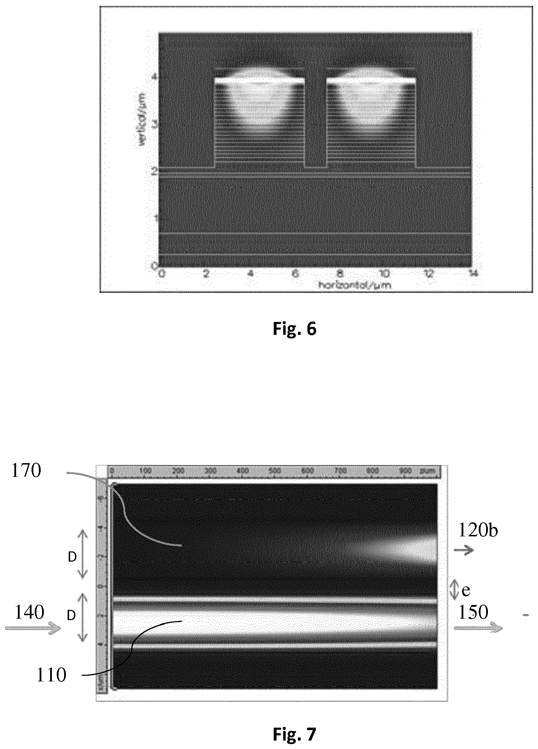

The **Figure 6** shows the cross-section of the coupled waveguides modelled and the propagation of the input signal and its coupling to a photodiode is shown on **Figure 7.**

In this modelling, the SOA medium 110 is represented as waveguide and has the same width D as the coupled waveguide 170 , which is 4 $\mu$m. They are approximately e~0.5 $\mu$m spaced.

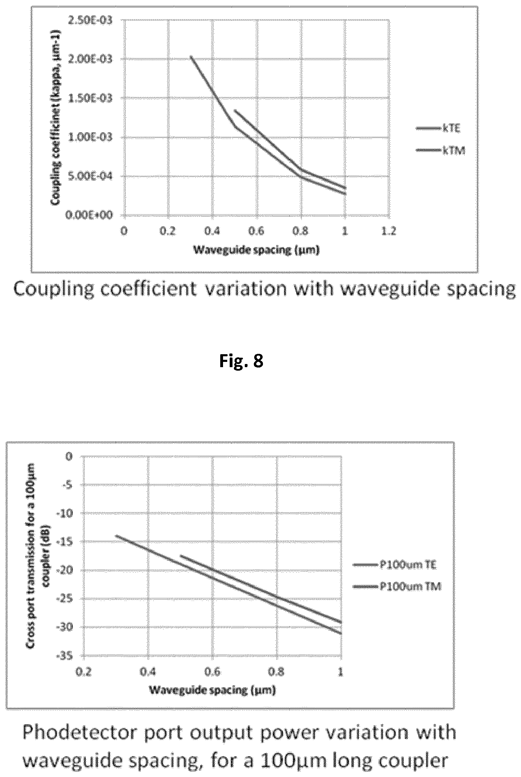

The coupling coefficient variation with waveguide spacing is shown on **Figure 8.** This graph reveals that the coupling coefficient between both waveguides mainly depends on waveguide spacing.

The photodetector port output power variation with the waveguide spacing for a 100 μm long coupler is shown on **Figure 9.** It is to be noted that, with a 100 μm long coupling section, it is possible to achieve a coupling efficiency of 1 % with 0.6 μm of waveguide spacing, and of 0.1 % with 1 μm of waveguide spacing. Depending on the power range of the SOA and its fabrication constraints, the waveguide spacing can be adjusted, with an impact on the coupling efficiency.

The invention has many advantages. It offers a low cost, compact and easy to produce SOA having an integrated gain measurement. Furthermore, it can be applied to a single polarization SOA to be integrated in a polarization diversity scheme, but also to polarization independent SOA as the coupled waveguide 170 can be made of the same materials as the first waveguide.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

**REFERENCES NUMERALS**

10 Erbium Doped Fibre Amplifier (EDFA)
20 Photodiode
30 1 % tap
40 Input power
50 Output power
100 Semiconductor Optical Amplifier (SOA) chip
110 Semiconductor Optical Amplifier (SOA) medium
120a First section
120b Second section
130 Photodiode
140 Input power
150 Output power
160 Amplified Spontaneous Emission (ASE)
160a Foreward ASE
160b Backward ASE
165a Reflected ASE
165b Reflected ASE
170 Coupled waveguide

**Claims**

1. A Semiconductor Optical Amplifier (100) comprising:

   - a Semiconductor Optical Amplifier medium (110) adapted to transmit and amplify an optical signal; and
   - integrated control means adapted to measure the gain of the Semiconductor Optical Amplifier (100).

2. The Semiconductor Optical Amplifier (100) of claim 1 wherein the control means comprise a first and second sections (120a, 120b), the first section (120a) being located at the input of the Semiconductor Optical Amplifier medium (110) and adapted to measure the input power (140) and, the second section (120b) being located at the output of the Semiconductor Optical Amplifier medium (110) and adapted to measure the output power (150).

3. The Semiconductor Optical Amplifier (100) of claim 2 wherein the first and second sections (120a and 120b) comprise:

   - a coupled waveguide (170) parallel to the Semiconductor Optical Amplifier medium (110) and adapted to sample the optical signal passing through the Semiconductor Optical Amplifier medium (110); and
   - a photodiode (130) implemented at the extremity of the coupled waveguide (170) and adapted to measure the power of the signal sampled by the coupled waveguide (170).

4. The Semiconductor Optical Amplifier (100) of claim 3 wherein the distance between the Semiconductor Optical Amplifier medium (110) and the coupled waveguide (170) is adapted to make sure that the monitoring will not lead to reflections and/or optical losses.

5. The Semiconductor Optical Amplifier (100) of claim 3 or 4 wherein the input and output facets of the Semiconductor Optical Amplifier medium (110) are tilted, and the first an second sections (120a and 120b) are located at the opposite of the tilts (θa and θb) so that an Amplified Spontaneous Emission (160) generated in the Semiconductor Optical Amplifier (100) would not be detected by the photodiodes (130) of the first and second section (120a, 120b).

10

20

40

20

30

30

50

**Fig. 1**

100

120a

110

120b

140

160b

160a

150

**Fig. 2**

100

120a

110

120b

140

160b

160a

150

**Fig. 2**

100

130    110    130

140 →    ←160b    160a→    → 150

170    120a    170    120b

**Fig. 4**

θa

140    130    110    170    130    120b

165a    160

100    170    120a    165b    150

θb

**Fig. 5**

**Fig. 6**

**Fig. 7**

Coupling coefficient variation with waveguide spacing

**Fig. 8**

Phodetector port output power variation with waveguide spacing, for a 100µm long coupler

Europäisches
Patentamt

European
Patent Office

Office européen
des brevets

## EUROPEAN SEARCH REPORT

Application Number

EP 17 30 5283

### DOCUMENTS CONSIDERED TO BE RELEVANT

| Category | Citation of document with indication, where appropriate, of relevant passages | Relevant to claim | CLASSIFICATION OF THE APPLICATION  (IPC) |
|---|---|---|---|
| X | US 2006/221438 A1 (AKIYAMA TOMOYUKI [JP]) 5 October 2006 (2006-10-05) fig.1,7,12 par.53 sq.; * abstract * | 1,2,4,5 | INV. H01S5/026 H01S5/10 H01S5/50 |
| X | US 2005/041280 A1 (LEE JEONG-SEOK [KR] ET AL) 24 February 2005 (2005-02-24) fig.1,7,12 par.53; * abstract * | 1-4 | |

TECHNICAL FIELDS
SEARCHED      (IPC)

H01S

The present search report has been drawn up for all claims

| Place of search | Date of completion of the search | Examiner |
|---|---|---|
| Munich | 10 October 2017 | Lendroit, Stéphane |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 17 30 5283

This annex lists the patent family members relating to the patent documents cited in the above-mentioned European search report.
The members are as contained in the European Patent Office EDP file on
The European Patent Office is in no way liable for these particulars which are merely given for the purpose of information.

10-10-2017

| Patent document cited in search report | | Publication date | Patent family member(s) | | Publication date |
|---|---|---|---|---|---|
| US 2006221438 | A1 | 05-10-2006 | JP | 4632841 B2 | 23-02-2011 |
| | | | JP | 2006286810 A | 19-10-2006 |
| | | | US | 2006221438 A1 | 05-10-2006 |
| US 2005041280 | A1 | 24-02-2005 | CN | 1584652 A | 23-02-2005 |
| | | | JP | 3895342 B2 | 22-03-2007 |
| | | | JP | 2005072579 A | 17-03-2005 |
| | | | KR | 20050023124 A | 09-03-2005 |
| | | | US | 2005041280 A1 | 24-02-2005 |

EPO FORM P0459

For more details about this annex : see Official Journal of the European Patent Office, No. 12/82